# EUROPEAN PATENT APPLICATION

(11) **EP 4 199 115 A1**
(43) Date of publication of application: **21.06.2023**
(21) Application number: 21215532.9
(22) Date of filing: 17.12.2021
(51) Int. Cl.: H01L 29/778, H01L 29/417, H01L 21/336, H01L 29/16, H01L 29/41, B82Y 10/00, H01L 29/423, H01L 29/24

(54) **TRANSISTOR WITH LOW PARASITIC CAPACITANCE**

(71) Applicant: IMEC VZW, 3001 Leuven (BE)
(72) Inventor: SMETS, Quentin, 1030 Schaarbeek (BE); RADU, Iuliana, 3001 Heverlee (BE); SCHRAM, Tom, 1330 Rixensart (BE); AHMED, Zubair, 3001 Leuven (BE)
(74) Representative: AWA Sweden AB

(57) **Abstract**

According to an aspect of the present inventive concept there is provided a 2D transistor device (100). The 2D transistor device (100) comprises: a 2D semiconductor layer (110) comprising a source-side extension portion (112), a drain-side extension portion (116) and a channel portion (114) extending between the extension portions (112, 116) along a channel direction (300); a gate electrode (120) arranged along and being coextensive with the channel portion (114); a source-side 2D metal contact (132) arranged in abutment with the source-side extension portion (112) and spaced apart from the gate electrode (120) along the channel direction (300); and a drain-side 2D metal contact (136) arranged in abutment with the drain-side extension portion (116) and spaced apart from the gate electrode (120) along the channel direction (300).

A method (150) for forming such a device (100) and a system (200) comprising at least two such devices (100) are also provided.

## Description

### Technical field

The present inventive concept relates to a transistor and a method to manufacture such. In particular, the present inventive concept relates to a 2D transistor with low parasitic capacitance.

### Background

In the prior art, parasitic capacitance between the different electrodes of the transistor is considered an unwanted but unavoidable part of transistor design. In many logic applications, such parasitic capacitance is not impactful enough to design around and other aspects such as size scaling is prioritized.

However, in logic applications where very fast switching speed is important, parasitic capacitance may cause RC delay that limits a switching speed of the transistor.

### Summary

Accordingly, there is a need for a transistor design with a reduced parasitic capacitance. It would be further beneficial is such a transistor design is also scalable. An objective of the present inventive concept is to provide such a transistor design.

According to a first aspect of the present inventive concept there is provided a two-dimensional (2D) transistor device. The 2D transistor device comprises: a 2D semiconductor layer comprising a source-side extension portion, a drain-side extension portion and a channel portion extending between the extension portions along a channel direction; a gate electrode arranged along and being coextensive with the channel portion; a source-side 2D metal contact arranged in abutment with the source-side extension portion and spaced apart from the gate electrode along the channel direction; and a drain-side 2D metal contact arranged in abutment with the drain-side extension portion and spaced apart from the gate electrode along the channel direction.

By the term 2D is meant a layer that is a single or a few mono-atomic layers thick. The term "2D transistor device" is accordingly meant as a transistor that comprises at least a channel portion that is part of a layer that is a single or a few monolayers thick.

The 2D transistor device may be a field effect transistor with a dielectric separating the channel portion and the gate electrode.

By the 2D metal contacts being arranged in abutment with the extension portions of the semiconductor layer, the 2D metal contacts are in direct contact with the extension portions.

A transistor device according to the first aspect thereby minimizes a parasitic capacitance between the gate electrode and conventional source and drain electrodes in that the 2D metal contacts are 2D metals and thereby has a much smaller capacitive interface to the gate electrode compared to a 3D electrode.

According to one embodiment the source-side 2D metal contact and the drain-side 2D metal contact are arranged in the same layer as the semiconductor layer.

By arranging the 2D metal contacts in the same layer as the semiconductor layer, the capacitive coupling between the 2D contacts and the gate electrode is further reduced by the 2D contacts being offset from the gate electrode in a direction transverse to the channel direction.

Additionally, a higher current density could be achieved compared to e.g. arranging the 2D metal contacts on top of the semiconductor layer. This because the 2D metal may be covalently bonded in-plane (i.e. along the same layer) and van der Waal bonded out-of-plane. Accordingly, the interface between the 2D metal contacts and the semiconductor could have a lower resistivity in this arrangement due to a lower resistivity of the covalent bonding compared to the van der Waal bonding.

According to one embodiment the source-side 2D metal contact and the drain-side 2D metal contact are spaced apart from the gate electrode along the channel direction by 0-5 nm, such as 3 nm or 5 nm.

Such a relatively short distance reduces the effect of the resistivity of the extension portions of the 2D semiconductor layer. Thereby, charge carriers may still flow with sufficiently high current density between the source-side 2D metal contact and the drain-side 2D metal contact via a channel induced by the gate electrode in the channel portion.

According to one embodiment the gate electrode is a first gate electrode and the device further comprises a second gate electrode arranged along the opposite side of the semiconductor layer than the first gate electrode and being coextensive with the channel portion.

The two gates enable better electrostatic control over the channel portion.

According to one embodiment the gate electrode is a 2D layer parallel with the 2D semiconductor layer.

The 2D gate electrode further reduces the parasitic capacitance between the gate electrode and the 2D metal contacts.

According to one embodiment the gate electrode is a first 2D gate electrode and the device further comprises a second 2D gate electrode arranged parallel with the 2D semiconductor layer along the opposite side of the semiconductor layer than the first 2D gate electrode and being coextensive with the channel portion.

This enables better electrostatic control over the channel portion while still enabling a low parasitic capacitance between the gate electrodes and the 2D metal contacts.

According to one embodiment the device further comprises a 2D gate dielectric arranged between the gate electrode(s) and the semiconductor layer and being coextensive with the channel portion.

By arranging a 2D gate dielectric in contact with the 2D semiconductor layer, the interface quality may be improved because stacked 2D layers on top of each other will have a more defect-free van der Waals interface. This may in principle be better than mixing 2D materials with bulk materials that possibly have unpassivated dangling bonds that introduce defects.

According to one embodiment the device further comprises a source electrode arranged in abutment with the source-side 2D metal contact and arranged on an opposite side along the channel direction of the source-side 2D metal contact than the gate electrode; and a drain electrode arranged in abutment with the drain-side 2D metal contact and arranged on an opposite side along the channel direction of the drain-side 2D metal contact than the gate electrode.

The source and drain electrodes are thereby arranged to enable simple integration with e.g. back-end of line while still minimizing parasitic capacitance between the source and drain electrodes and the gate electrode(s) by the arrangement on the opposite sides than the gate electrode(s).

According to a second aspect of the present inventive concept, a system is provided comprising at least a first and second device according to the first aspect. The first and second device are arranged in series with each other such that the drain-side 2D metal contact of the first device and the source-side 2D metal contact of the second device is the same bridging 2D metal contact.

Thereby several devices may be connected in a simple manner that also minimizes parasitic capacitance.

In a similar manner, more than two devices may be arranged in series with each other.

According to one embodiment the system further comprises a source electrode arranged in abutment with the source-side 2D metal contact of the first device and arranged on an opposite side along the channel direction of the source-side 2D metal contact than the gate electrode of the first device; and a drain electrode arranged in abutment with the drain-side 2D metal contact of the second device and arranged on an opposite side along the channel direction of the drain-side 2D metal contact than the gate electrode of the second device.

The source and drain electrodes are thereby arranged to enable simple integration with e.g. back-end of line while still minimizing parasitic capacitance between the source and drain electrodes and the gate electrodes by the arrangement on the opposite sides than the gate electrodes.

According to one embodiment the first device forms part of an NFET and the second device forms part of a PFET.

This is a way to design a CMOS with relatively very low parasitic capacitance.

In alternate embodiments, the first device forms part of an PFET and the second device forms part of a NFET.

According to a third aspect of the present inventive concept a method is provided for forming a 2D transistor device according to the first aspect. The method comprises steps of: depositing a 2D metal; patterning the 2D metal to form the source-side 2D metal contact and the drain-side 2D metal contact; selectively forming a 2D semiconductor layer between the source-side 2D metal contact and the drain-side 2D metal contact, the semiconductor layer comprising a source-side extension portion, a drain-side extension portion and a channel portion extending between the extension portions along a channel direction; depositing a gate dielectric on the semiconductor layer; depositing a gate metal on the gate dielectric; patterning the gate metal to form a gate electrode being coextensive with the channel portion.

This aspect may generally present the same or corresponding advantages as the former aspect.

The gate dielectric may be a high-k dielectric and patterned together with the gate metal to be coextensive with the channel portion.

The gate dielectric may be a 2D layer.

According to one embodiment the method further comprises steps of: depositing a gate metal; patterning the gate metal to form another gate electrode being coextensive with the channel portion; and depositing a gate dielectric; wherein these steps are performed before performing the step of depositing a 2D metal.

Thereby, a second gate may be formed for enabling better electrostatic control over the channel portion.

As an alternative to the third aspect, instead of selectively forming a 2D semiconductor layer between the source-side metal contact and the drain-side 2D metal contact, the 2D semiconductor layer may be deposited in a non-selective manner either on the 2D metal contacts or before the 2D metal contacts are formed, whereby the 2D metal contacts are formed on top of the 2D semiconductor layer.

### Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1 is a schematic illustration of an example of a prior art 2D transistor.
Fig. 2 is a schematic illustration of an embodiment of the inventive concept.
Fig. 3 is a schematic illustration of an embodiment of the inventive concept.
Fig. 4 is a schematic illustration of an embodiment of the inventive concept.
Fig. 5 is a schematic illustration of an embodiment of the inventive concept.
Fig. 6 is a schematic illustration of an embodiment of a system according to the inventive concept.
Figs. 7a-e is a schematic illustration of results of different steps of a method according to the inventive concept.
Figs. 8a-c is a schematic illustration of results of different steps of a method according to the inventive concept.

### Detailed description

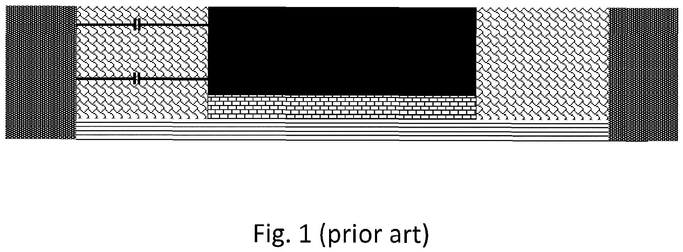

Fig. 1 illustrates a prior art example of a 2D transistor. A capacitance between the gate electrode and the source electrode of the prior art device is marked in Fig. 1. A similar capacitance also exists between the gate electrode and the drain electrode, but this is not marked in Fig. 1.

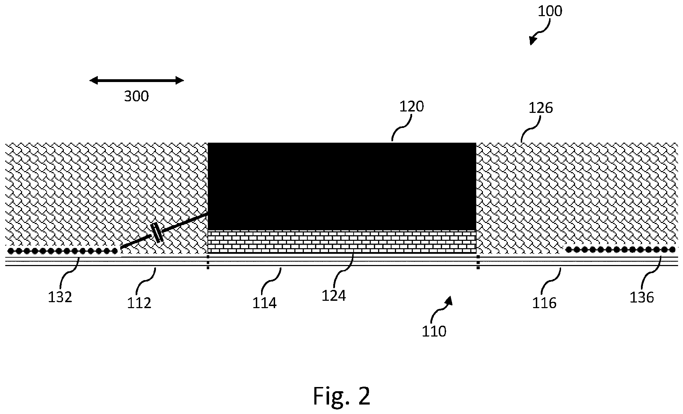

Fig. 2 illustrates a 2D transistor device 100. The device 100 comprises a 2D semiconductor layer 110 comprising a source-side extension portion 112, a drain-side extension portion 116 and a channel portion 114 extending between the extension portions 112, 116 along a channel direction 300.

The 2D semiconductor layer 110 may e.g. be made from graphene, silicene, germanene, transition metal dichalcogenides MX₂ where M=Mo, W, or Hf and X=S, Se, or Te, or other suitable 2D materials.

The device 100 also comprises a gate electrode 120 and a gate dielectric 124 arranged along and being coextensive with the channel portion 114. The gate electrode 120 may be made from conventional gate metals such as Ti, TiN, and W and the gate dielectric 124 may be made from conventional high-k gate dielectric materials such as SiO₂, Al₂O₃ and HfO₂.

The gate dielectric 124 may be a 2D layer.

The device 100 further comprises a source-side 2D metal contact 132 arranged in abutment with the source-side extension portion 112 and spaced apart from the gate electrode 120 along the channel direction 300; and a drain-side 2D metal contact 136 arranged in abutment with the drain-side extension portion 116 and spaced apart from the gate electrode 120 along the channel direction 300.

The 2D metal contacts 132, 136 may be made from layered 2D metal materials, e.g. chosen from a group consisting of: TaS, TaSe, LaOBr, LaOCI, CaHl, SrBrF, SrHBr, SrHI, TIF, Fe, Ga, Sn, Sb, InSb, Cu, Ag, Pb, Bi, 1T-TaS₂, Bi₂Te₃. The 2D metal contacts 132, 136 may alternatively be made from a metal with a hexagonal, honeycomb, or puckered lattice geometry.

A capacitance is marked in Fig. 2 between the gate electrode 120 and the source-side 2D metal contact 132. Compared to the prior art example of Fig. 1, the source-side 2D metal contact 132 has a smaller capacitive interface to the gate electrode 120 compared to a 3D source electrode.

A similar capacitance also exists between the gate electrode 120 and the drain-side 2D metal contact 136, but this is not marked in Fig. 2.

The device 100 additionally comprises a spacer dielectric 126. The spacer dielectric 126 preferably has a lower dielectric constant than the gate dielectric 124, e.g. a low-k dielectric or silicon dioxide.

The gate electrode 120 may electrostatically induce an electron or hole accumulation layer in the channel portion 114 by a voltage being applied to the gate electrode 120. A resistivity of the semiconductor layer 110 may thereby be lowered to enable a signal to propagate between the source-side 2D metal contact 132 to the drain-side 2D metal contact 136.

The source-side 2D metal contact 132 and the drain-side 2D metal contact 136 are spaced apart from the gate electrode 120 along the channel direction 300 by 5 nm.

A distance of 5 nm or lower may limit the effect of the resistivity of the extension portions 112, 116 of the 2D semiconductor layer 110 to increase a current density between the source-side 2D metal contact 132 and the drain-side 2D metal contact 136.

At such a relatively short distance, the relatively large parasitic capacitance between the gate electrode 120 and the 2D metal contacts 132, 136 may deteriorate a switching speed of the device 100. Accordingly, the 2D nature of the 2D metal contacts 132, 136 greatly reduces the parasitic capacitance compared to the source and drain electrodes of the prior art device of Fig. 1.

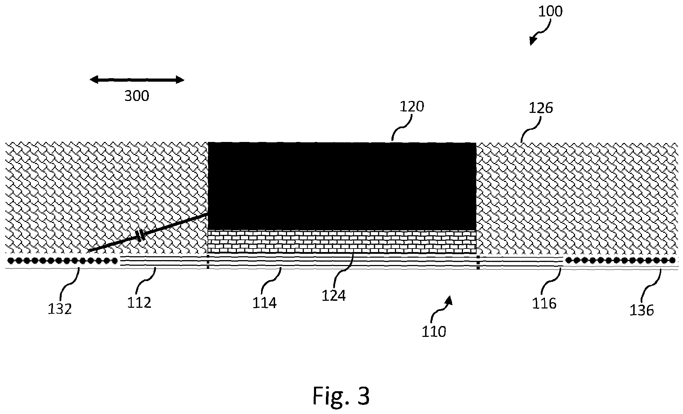

Fig. 3 illustrates an alternative 2D transistor device 100. Compared to the device 100 of Fig. 2, in the device 100 of Fig. 3, the source-side 2D metal contact 132 and the drain-side 2D metal contact 136 are arranged in the same layer as the semiconductor layer 110.

Similar dimensions and material choices as discussed in relation to Fig. 2 also applies mutatis mutandis for Fig. 3.

This arrangement may increase a current density in the semiconductor layer 110 because the physical bond of this arrangement is less resistive than e.g. the one in Fig. 2.

Additionally, this arrangement causes the 2D metal contacts 132, 136 to be offset from the gate electrode 120 in a direction transverse to the channel direction 300. The 2D metal contacts 132, 136 are thereby farther away from the gate electrode 120 than the one in Fig. 2, which further lowers the parasitic capacitance.

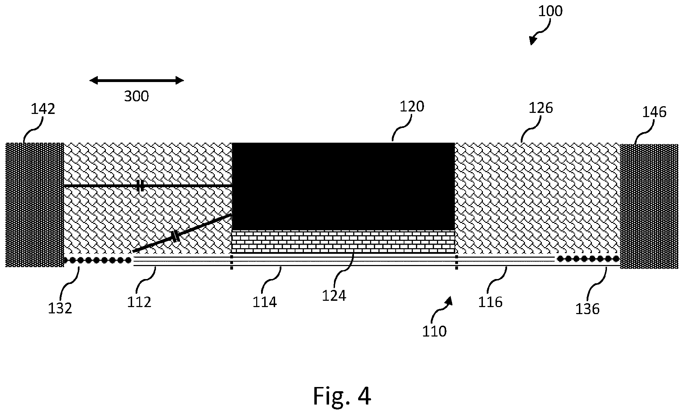

Fig. 4 illustrates an alternative 2D transistor device 100. Compared to the device 100 of Fig. 3, the device 100 of Fig. 4 further comprises a source electrode 142 arranged in abutment with the source-side 2D metal contact 132 and arranged on an opposite side along the channel direction 300 of the source-side 2D metal contact 132 than the gate electrode 120; and a drain electrode 146 arranged in abutment with the drain-side 2D metal contact 136 and arranged on an opposite side along the channel direction 300 of the drain-side 2D metal contact 136 than the gate electrode 120.

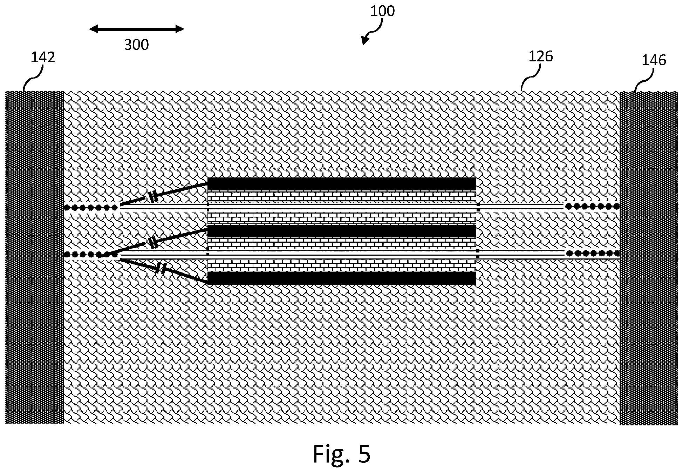

The source and drain electrodes 142, 146 may be conventional electrodes, i.e. not made from a 2D metal. The electrodes 142, 146 may be metal blocks connecting several layers of 2D metal contacts 132, 136 together, as shown e.g. in Fig. 5.

A parasitic capacitance between the source electrode 142 and the gate electrode 120 is marked in Fig. 4. A similar parasitic capacitance between the drain electrode 146 and the gate electrode 120 also exists but is not marked in Fig. 4.

Compared to the prior art example of Fig. 1, the source and drain electrodes 142, 146 of Fig. 4 may be arranged farther away from the gate electrode 120 in the channel direction 300, which reduces the parasitic capacitance. This increase in distance is facilitated by the 2D metal contacts 132, 136, which enable a signal between the source and drain electrodes 142, 146 to propagate to the semiconductor layer 110 through the 2D metal contacts 132, 136 without significant resistance.

The distance that a signal is propagated through the extension portions 112, 116 of the 2D semiconductor layer 110 may be controlled by the arrangement of the 2D metal contacts 132, 136, which have a (much) lower resistivity than the extension portions 112, 116 of the semiconductor layer 110. The charge carriers of the signal may thereby only propagate in the extension portions 112, 116 of the semiconductor layer 110 wherever the 2D metal contacts 132, 136 are not in contact with the extension portions 112, 116, i.e. the distance the source-side 2D metal contact 132 and the drain-side 2D metal contact 136 are spaced apart from the gate electrode 120 along the channel direction 300.

Accordingly, the source and drain electrodes 142, 146 may be spaced farther away from the gate electrode 120, without significantly affecting the current density of the signal between them, by a distance equal to the length of the 2D metal contacts 132, 136 in the channel direction 300, which may e.g. be 1-10 nm such as 3 or 5 nm.

Because this distance is bridged by a 2D metal, the parasitic capacitance between the gate electrode 120 and the combination of the source and drain electrodes 142, 146 and the 2D metal contacts 132, 136 is much smaller than the prior art example in Fig. 1 not having 2D metal contacts.

Fig. 5 illustrates an alternative 2D transistor device 100. Compared to the device 100 of Figs. 2-4, the device 100 of Fig. 5 comprises two semiconductor layers, two sets of 2D metal contacts, three gate electrodes and four gate dielectric layers, wherein the gate electrodes and gate dielectrics are 2D layers.

It is noted that these differences are not necessarily interrelated. For example, the device 100 may comprise more than one gate electrode that are not 2D layers or a single 2D layered gate electrode.

All of the gate electrodes are coextensive with the channel portions of the semiconductor layers. Additionally, a gate dielectric is arranged between each semiconductor layer and each gate electrode that are also coextensive with the channel portions of the semiconductor layers.

A first gate electrode and a second gate electrode are arranged along opposite sides of the topmost semiconductor layer. This may enable a better electrostatic control over the channel portion.

By the gate electrodes being 2D layers, a parasitic capacitance between the gate electrodes 121, 122, 123 and the 2D metal contacts is reduced compared to conventional gate electrodes.

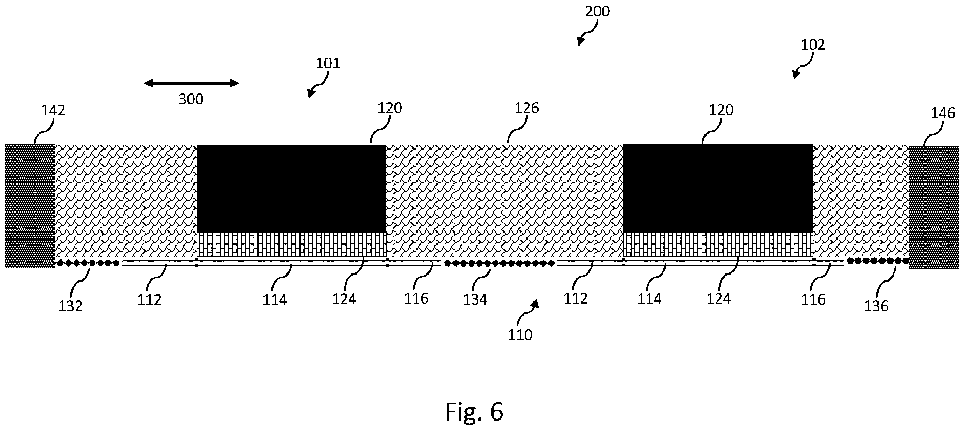

Fig. 6 illustrates a system 200 comprising a first device 101 and a second device 102, that may each be a device 100 as described in relation to Figs. 2-5.

The first and second device 101, 102 are arranged in series with each other such that the drain-side 2D metal contact of the first device 101 and the source-side 2D metal contact of the second device 102 is the same bridging 2D metal contact 134.

Accordingly, the output of the first device 101 may act as input for the second device 102, resulting in a cascadeable system 200.

Any number of devices may be arranged in series in this way.

The source electrode 142 is arranged in abutment with the source-side 2D metal contact 132 of the first device 101 and arranged on an opposite side along the channel direction 300 of the source-side 2D metal contact 132 than the gate electrode 120 of the first device 101.

The drain electrode 146 is arranged in abutment with the drain-side 2D metal contact 136 of the second device 102 and arranged on an opposite side along the channel direction 300 of the drain-side 2D metal contact 136 than the gate electrode 120 of the second device 102.

Hence, at the ends of the system 200, source and drain electrodes 142, 146 may be arranged. Thereby only a single source electrode 142 and a single drain electrode 146 may be arranged as a signal between them may cascade across any number of devices in series.

The two devices 101, 102 of the system 200 may together form a CMOS by e.g. the first device 101 forming part of an NFET and the second device 102 forming part of a PFET, or vice versa.

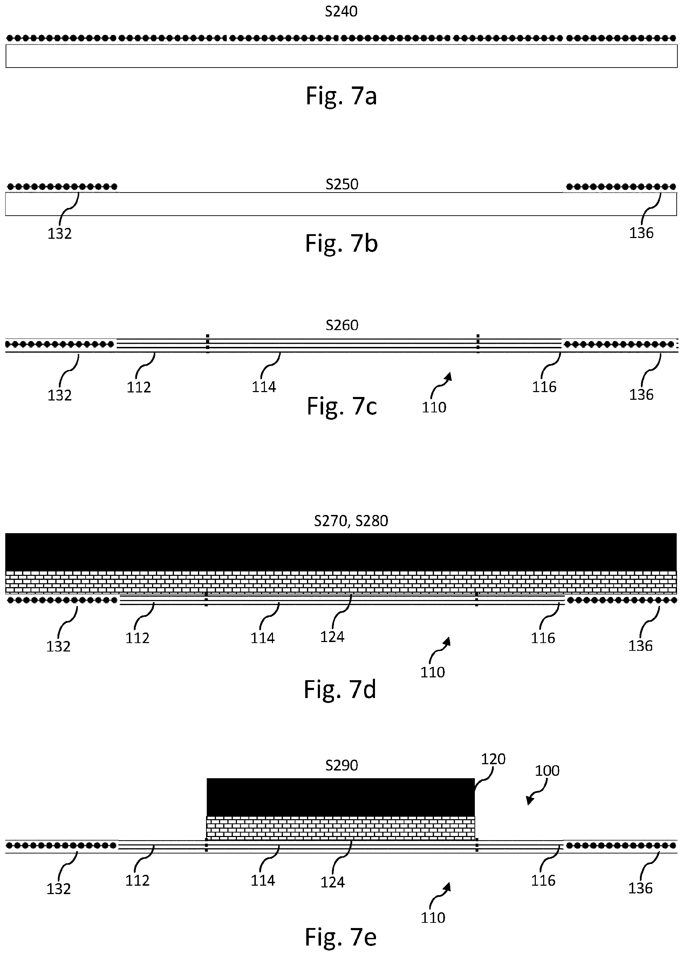

Figs. 7a-e illustrate different end results of different, sequential processing steps of a method for forming a 2D transistor device 100 as described in relation to Figs. 3-5.

Fig. 7a shows a 2D metal on top of a substrate, which follows a step of depositing S240 a 2D metal. The substrate may be an insulator such as silicon dioxide and is only shown in Figs. 7a and 7b for the sake of visual clutter, the substrate may always be present also in relation to Figs. 1-7.

Fig. 7b shows the 2D metal after being patterned S250 to form a source-side 2D metal contact 132 and a drain-side 2D metal contact 136.

Fig. 7c shows a 2D semiconductor layer 110 having been selectively formed S260 between the source-side 2D metal contact 132 and the drain-side 2D metal contact 132.

The semiconductor layer 110 comprises a source-side extension portion 112, a drain-side extension portion 116 and a channel portion 114 extending between the extension portions 112, 116 along a channel direction.

Accordingly, the semiconductor layer 110 may be self-aligned with the 2D metal contacts 132, 136.

In Fig. 7d, a gate dielectric 124 has been deposited S270 on the semiconductor layer 110 and the 2D metal contacts 132, 136 and a gate metal has been deposited S280 on the gate dielectric 124.

Alternatively, the gate dielectric 124 may be deposited only on the semiconductor layer 110.

In Fig. 7e, the gate metal and gate dielectric 124 have been patterned S290 to form a gate electrode 120 and a gate dielectric 124 being coextensive with the channel portion 114.

Alternatively, the gate dielectric 124 may be formed coextensive with the channel portion 114 using e.g. masks or patterning. Then, the gate metal may be selectively formed on top of the gate dielectric 124 to be coextensive with the channel portion 114.

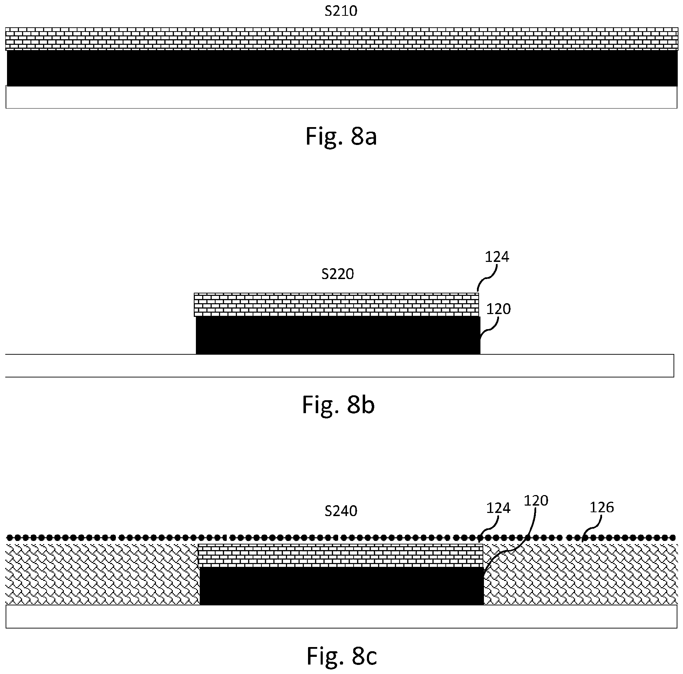

Figs. 8a-c illustrate different end results of different, sequential processing steps of a method for forming a gate electrode 120 below the semiconductor layer. The processing steps in Fig. 8 and Fig. 7 may be combined and repeated sequentially to obtain a device similar to the one in Fig. 5. A gate metal and gate dielectric 124 may be deposited S210 and patterned S220 to form the gate electrode 120 and gate dielectric 124 being coextensive with the channel portion.

Alternatively, a gate dielectric 124 may be deposited on top of the patterned gate electrode 120 in a self-aligned manner.

The steps of Fig. 8 may be performed before depositing 240 the 2D metal as in Fig. 7a.

Fig. 8a shows a gate metal and gate dielectric on top of a substrate, which follows a step of depositing 210 a gate metal and gate dielectric.

Fig. 8b shows the gate metal and gate dielectric 124 after being patterned S220 to form the gate electrode 120.

Fig. 8c shows a 2D metal after being depositing S240, which may further follow a filling step where a spacer dielectric 126 is deposited.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A 2D transistor device (100) comprising:
a 2D semiconductor layer (110) comprising a source-side extension portion (112), a drain-side extension portion (116) and a channel portion (114) extending between the extension portions (112, 116) along a channel direction (300);
a gate electrode (120) arranged along and being coextensive with the channel portion (114);
a source-side 2D metal contact (132) arranged in abutment with the source-side extension portion (112) and spaced apart from the gate electrode (120) along the channel direction (300); and
a drain-side 2D metal contact (136) arranged in abutment with the drain-side extension portion (116) and spaced apart from the gate electrode (120) along the channel direction (300).

2. A device according to claim 1, wherein the source-side 2D metal contact (132) and the drain-side 2D metal contact (136) are arranged in the same layer as the semiconductor layer (110).

3. A device according to claim 1 or 2, wherein the source-side 2D metal contact (132) and the drain-side 2D metal contact (136) are spaced apart from the gate electrode (120) along the channel direction (300) by 0-5 nm.

4. A device according to any one of the preceding claims, wherein the gate electrode is a first gate electrode (121) and the device (100) further comprises a second gate electrode (122) arranged along the opposite side of the semiconductor layer (110) than the first gate electrode (121) and being coextensive with the channel portion (114).

5. A device according to any one of the preceding claims, wherein the gate electrode (120) is a 2D layer parallel with the 2D semiconductor layer (110).

6. A device according to claim 5, wherein the gate electrode is a first gate electrode (121) and the device (100) further comprises a second 2D gate electrode (122) arranged parallel with the 2D semiconductor layer (110) along the opposite side of the semiconductor layer (110) than the first gate electrode (121) and being coextensive with the channel portion (114).

7. A device according to any one of the preceding claims, further comprising a 2D gate dielectric (124) arranged between the gate electrode(s) (120) and the semiconductor layer (110) and being coextensive with the channel portion (114).

8. A device according to any one of the preceding claims, further comprising a source electrode (142) arranged in abutment with the source-side 2D metal contact (132) and arranged on an opposite side along the channel direction (300) of the source-side 2D metal contact (132) than the gate electrode (120); and
a drain electrode (146) arranged in abutment with the drain-side 2D metal contact (136) and arranged on an opposite side along the channel direction (300) of the drain-side 2D metal contact (136) than the gate electrode (120).

9. A system (150) comprising at least a first and second device (101, 102) according to any one of the claims 2-7, wherein the first and second device (101, 102) are arranged in series with each other such that the drain-side 2D metal contact (136) of the first device (101) and the source-side 2D metal contact (132) of the second device (101) is the same bridging 2D metal contact (134).

10. A system according to claim 9, further comprising a source electrode (142) arranged in abutment with the source-side 2D metal contact (132) of the first device (101) and arranged on an opposite side along the channel direction (300) of the source-side 2D metal contact (132) than the gate electrode (120) of the first device (101); and
a drain electrode (146) arranged in abutment with the drain-side 2D metal contact (136) of the second device (102) and arranged on an opposite side along the channel direction (300) of the drain-side 2D metal contact (136) than the gate electrode (120) of the second device (102).

11. A system according to claim 9 or 10, wherein the first device (101) forms part of an NFET and the second device (102) forms part of a PFET.

12. A method (200) for forming a 2D transistor device (100) according to any one of the claims 1-8, the method (200) comprising steps of:
depositing (S240) a 2D metal;
patterning (S250) the 2D metal to form the source-side 2D metal contact and the drain-side 2D metal contact;
selectively forming (S260) a 2D semiconductor layer between the source-side 2D metal contact and the drain-side 2D metal contact, the semiconductor layer comprising a source-side extension portion, a drain-side extension portion and a channel portion extending between the extension portions along a channel direction;
depositing (S270) a gate dielectric on the semiconductor layer;
depositing (S280) a gate metal on the gate dielectric;
patterning (S290) the gate metal to form a gate electrode being coextensive with the channel portion.

13. A method for forming a 2D transistor device according to claim 12, further comprising steps of:
depositing (S210) a gate metal and a gate dielectric; and
patterning (S220) the gate metal and gate dielectric to form another gate electrode being coextensive with the channel portion;
wherein these steps are performed before performing the step of depositing (S240) a 2D metal.
